# EUROPEAN PATENT APPLICATION

(11) **EP 1 802 190 A1**
(43) Date of publication of application: **27.06.2007**
(21) Application number: 05782388.2
(22) Date of filing: 12.09.2005
(51) Int. Cl.: H05K 9/00, G02F 1/1345, H04M 1/02, H05F 3/02

(54) **PORTABLE RADIO**

(30) Priority: 28.09.2004 JP 2004281083
(71) Applicant: MATSUSHITA ELECTRIC INDUSTRIAL CO., LTD., Osaka 571-8501 (JP)
(72) Inventor: KOBAYASHI, Masa-aki c/o Matsushita Elec.Ind. Co., Ltd., Chuo-ku, Osaka 540-6319 (JP); HIRAI, Koutaro c/o Matsushita Electric Ind. Co., Ltd., Chuo-ku, Osaka 540-6319 (JP); KOZAI, Shinji c/o Matsushita Electric Ind. Co., Ltd., Chuo-ku, Osaka 540-6319 (JP)
(74) Representative: Grünecker, Kinkeldey, Stockmair & Schwanhäusser Anwaltssozietät
(86) International application number: PCT/JP2005/016736
(87) International publication number: WO 2006/035592

(57) **Abstract**

A mobile radio capable of reliably preventing static electricity from entering a liquid crystal display element is provided.

A mobile radio 10 includes an upper circuit board 17 housed in an upper cabinet 11 and connected to a liquid crystal display element 16, a lower circuit board 24 housed in a lower cabinet 12, upper and lower connectors 18 and 25 provided on the upper and lower circuit boards 17 and 24, and a coaxial cable 30 for connecting the connectors 18 and 25, thereby electrically connecting the upper and lower circuit boards 17 and 24. A line 31 passing through the center of the coaxial cable 30 is used as a signal line and is also used as a signal-dedicated ground, and an outer sheath 32 of the coaxial cable 30 is electrically connected to the upper cabinet 11 and is also electrically connected to a ground 28A of a battery 28 in the lower cabinet 12.

## Description

### <Technical Field>

This invention relates to a mobile radio provided with a liquid crystal display element on an upper cabinet and a power supply and a power ground in a lower cabinet and designed for protecting the liquid crystal display element provided on the upper cabinet and the circuitry in the upper cabinet from static electricity.

### <Background Art>

In recent years, a mobile telephone has been put into widespread use. The mobile telephone is made up of upper and lower cabinets and has a liquid crystal display element provided on the upper cabinet. The liquid crystal display element is comparatively sensitive to static electricity; static electricity enters from the upper cabinet in contact with the head of the user during telephone conversation or enters because of discharge when the user picks up the mobile telephone and the entering static electricity will destroy the liquid crystal display element or will cause a display anomaly to occur on a display section.

As means for solving this problem, for example, use of a noise filter or antistatic means is proposed.

The following is known as the noise filter for preventing the entry of static electricity:

A through hole is made in an electromagnetic absorption sheet having powder of soft magnetic material dispersed in a rubber or plastic matrix. A filter substrate is put on the surface of the electromagnetic absorption sheet and a Gnd (ground) substrate is put on the back of the electromagnetic absorption sheet.

The filter substrate is a substrate formed with a filter pattern on one flexible substrate provided with an electrically conductive material layer on one surface.

The Gnd substrate is a substrate formed with a Gnd pattern on another flexible substrate.

A connector including a signal pin and a Gnd pin is inserted into the through hole of the electromagnetic absorption sheet.

A filter equivalent circuit is formed in the filter pattern/electromagnetic absorption pattern/Gnd pattern and becomes a noise filter for preventing the entry of static electricity (for example, JP-A-2001-358580).

The following is known as the antistatic means for preventing the inflow of static electricity:

An antistatic layer is formed on the surface of a polarizing plate grounded to the top face of a liquid crystal display element and is connected to a ground pad of a printed-circuit board through a metal frame, thereby preventing static electricity from entering the liquid crystal display element (for example, JP-A-5-188388).

### <Disclosure of the Invention>

### <Problems to be Solved by the Invention>

However, if the noise filter or the antistatic means is used, it is difficult to reliably prevent static electricity from entering the liquid crystal display element and it is to be wished that an art capable of reliably preventing static electricity from entering the liquid crystal display element will become practical.

It is therefore an object of the invention to provide a mobile radio capable of reliably preventing static electricity from entering a liquid crystal display element and circuitry in an upper cabinet.

### <Means For Solving the Problems>

A mobile radio of the invention includes an upper cabinet and a lower cabinet which are connected in a stack state and can be changed in the relative position roughly stepwise; an upper circuit board being housed in the upper cabinet and connected to a liquid crystal display element; a lower circuit board being housed in the lower cabinet; an upper connector and a lower connector being provided on the upper circuit board and the lower circuit board respectively; and a coaxial cable for connecting the upper connector and the lower connector, thereby electrically connecting the upper circuit board and the lower circuit board, characterized in that a line passing through the center of the coaxial cable is used as a signal line and is also used as a signal-dedicated ground, and that an outer sheath of the coaxial cable is electrically connected to the upper cabinet and is also electrically connected to a ground of a power supply provided in the lower cabinet.

The outer sheath of the coaxial cable is electrically connected to the upper cabinet and is also electrically connected to the ground of the power supply provided in the lower cabinet. The ground of the power supply is zero potential.

To use the mobile radio for telephone conversion, the upper cabinet comes in contact with the user and static electricity entering from the upper cabinet is dissipated to the ground of the power supply in the lower cabinet through the outer sheath of the coaxial cable and the static electricity is reliably prevented from entering the liquid crystal display element and the circuitry in the upper cabinet.

### <Advantages of the Invention>

According to the invention, the static electricity entering from the upper cabinet is dissipated to the lower cabinet through the outer sheath of the coaxial cable, whereby the static electricity is reliably prevented from entering the liquid crystal display element, and destroying the liquid crystal display element due to static electricity and occurring of a display anomaly on the display section can be prevented reliably.

### <Brief Description of the Drawings>

FIG. 1 is an exploded perspective view to show an upper cabinet of a mobile radio according to the invention.
FIG. 2 is an exploded perspective view to show a lower cabinet of the mobile radio according to the invention.
FIG. 3 is a sectional view to show a coaxial cable used with the mobile radio according to the invention.

### <Description of Reference Numerals>

- 10: Mobile radio
- 11: Upper cabinet
- 12: Lower cabinet
- 16: Liquid crystal display element
- 17: Upper circuit board
- 18: Upper connector
- 24: Lower circuit board
- 25: Lower connector
- 28: Battery (power supply)
- 28A: Ground of battery
- 30: Coaxial cable
- 31: Line passing through center
- 32: Outer sheath

### <Best Mode for Carrying out the Invention>

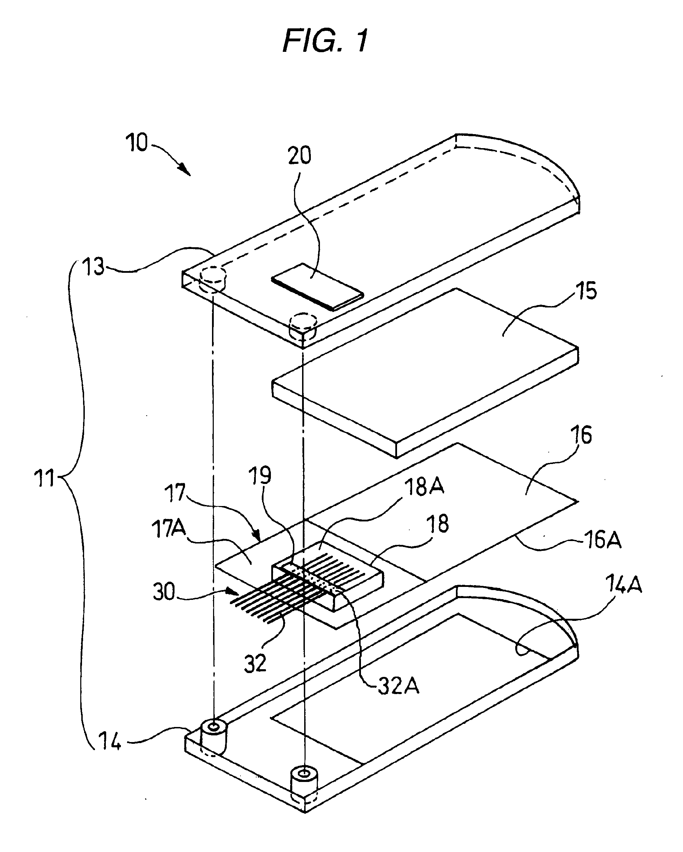

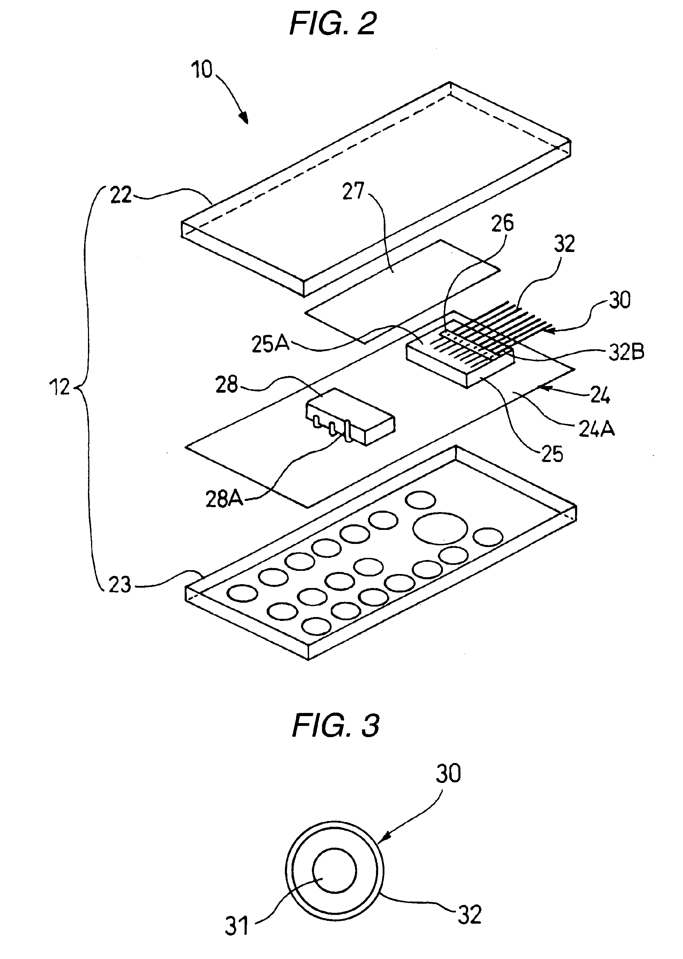

A mobile radio 10 of a first embodiment includes an upper cabinet 11 and a lower cabinet 12 which are connected in a stack state and can be changed in the relative position roughly stepwise, as shown in FIGS. 1 and 2.

The upper cabinet 11 is made up of an upper case 13 for the upper cabinet and a lower case 14 (display case) for the upper cabinet, and the upper case 13 for the upper cabinet and the lower case 14 for the upper cabinet are formed of an electrically conductive material of magnesium, etc.

The upper case 13 for the upper cabinet is provided with a liquid crystal display element 16 through a display element holder 15 and a terminal of an upper circuit board (mainly a display system and a voice output system) 17 is electrically connected to the liquid crystal display element 16.

That is, a circuit pattern is formed on the top face 17A of the upper circuit board 17 and the liquid crystal display element 16 is electrically connected to the circuit pattern.

A display surface 16A of the liquid crystal display element 16 faces an opening 14A of the lower case 14 for the upper cabinet with the lower case 14 for the upper cabinet assembled to the upper case 13 for the upper cabinet.

An upper connector 18 is electrically connected to the circuit pattern of the upper circuit board 17 and an electrically conductive material for ground (which will be hereinafter referred to as "upper ground member") 19 is provided on a housing top face 18A of the upper connector 18.

The upper ground member 19 is electrically connected to the electrically conductive upper case 13 through an upper spring member 20 with the lower case 14 for the upper cabinet assembled to the upper case 13 for the upper cabinet.

The display element holder 15, the liquid crystal display element 16, the upper circuit board 17, the upper connector 18, the upper ground member 19, and the upper spring member 20 are housed in the space formed by assembling the upper case 13 for the upper cabinet and the lower case 14 for the upper cabinet, namely, the space in the upper cabinet 11.

The lower cabinet 12 is made up of an upper case 22 for the lower cabinet and a lower case 23 (case on the key face side) for the lower cabinet. A lower circuit board 24 is housed in the space formed by assembling the upper case 22 for the lower cabinet and the lower case 23 for the lower cabinet.

A circuit pattern is formed on a top face 24A of the lower circuit board 24 and a terminal of a lower connector 25 is electrically connected to the circuit pattern.

An electrically conductive material for ground (which will be hereinafter referred to as "lower ground member") 26 is provided on a housing top face 25A of the lower connector 25.

The lower ground member 26 is electrically connected to a ground 28A of a battery (power supply) 28 through a lower electrically conductive plate 27 with the lower case 23 for the lower cabinet assembled to the upper case 22 for the lower cabinet.

The battery 28 is electrically connected to the circuit pattern of the lower circuit board 24.

The lower circuit board 24, the lower connector 25, the lower ground member 26, the lower electrically conductive plate 27, and the battery 28 are housed in the space formed by assembling the upper case 22 for the lower cabinet and the lower case 23 for the lower cabinet, namely, the space in the lower cabinet 12.

The upper connector 18 and the lower connector 25 are electrically connected by a coaxial cable 30.

The coaxial cable 30 is used as a signal line and is also used as a signal-dedicated ground as a line 31 passing through the center shown in FIG. 3 is electrically connected to a terminal of the upper connector 18 and a terminal of the lower connector 25.

The ground will be hereinafter referred to as "signal ground."

Further, the coaxial cable 30 includes an outer sheath 32 formed of an electrically conductive material and the outer sheath 32 has one end part 32A (see FIG. 1) electrically connected to the upper ground member 19 and an opposite end part 32B (see FIG. 2) electrically connected to the lower ground member 26.

Accordingly, the outer sheath 32 of the coaxial cable 30 is electrically connected to the upper cabinet 11 and is also grounded to the ground 28A of the battery 28 provided in the lower cabinet 12. The outer sheath 32 of the coaxial cable 30 becomes a ground, which will be hereinafter referred to as "field ground."

Since the ground 28A of the battery 28 is also connected to the signal ground, the signal ground and the field ground here become one-point connection.

The signal ground is not connected to the electrically conductive upper case 13.

That is, the field ground is a ground separated from the signal ground.

According to the mobile radio 10, the outer sheath 32 of the coaxial cable 30 is electrically connected to the upper cabinet 11 and is also electrically connected to the ground 28A of the battery 28 provided in the lower cabinet 12. The ground 28A of the battery 28 is zero potential.

To use the mobile radio 10 for telephone conversion, the upper cabinet 11 comes in contact with the user (not shown) and static electricity enters from the upper cabinet 11.

The entering static electricity is dissipated to the ground 28A of the battery 28 in the lower cabinet through the outer sheath 32 of the coaxial cable 30. Accordingly, static electricity can be reliably prevented from entering the liquid crystal display element 16.

In the description of the embodiment, the upper ground member 29 and the lower ground member 26 are provided on the housing top face 18A of the upper connector 18 and the housing top face 25A of the lower connector 25 respectively by way of example. However, the invention is not limited to the mode and the housings of the upper connector 18 and the lower connector 25 can also be formed of an electrically conductive material.

Further, in the description of the embodiment, the invention is applied to the mobile radio wherein the circuit pattern is formed on the top face 17A, 24A of the upper, lower circuit board 17, namely, only on one face by way of example. However, if the circuit pattern is formed on both faces of the upper, lower circuit board 17, similar advantages can also be provided by separating the signal ground and the field ground as in the embodiment described above.

This application is based on Japanese Patent Application (No. 2004-281083) filed on September 28, 2004, which is incorporated herein by reference.

### <Industrial Applicability>

The invention is suited to application to a mobile radio provided with a liquid crystal display element on an upper cabinet and a power supply and a power ground in a lower cabinet.

## Claims

1. A mobile radio, comprising:
an upper cabinet and a lower cabinet which are connected in a stack state and can be changed in the relative position roughly stepwise;
an upper circuit board being housed in said upper cabinet and connected to a liquid crystal display element;
a lower circuit board being housed in said lower cabinet;
an upper connector and a lower connector being provided on said upper circuit board and said lower circuit board respectively; and
a coaxial cable for connecting said upper connector and said lower connector, thereby electrically connecting said upper circuit board and said lower circuit board;
wherein a line passing through the center of said coaxial cable is used as a signal line and is used as a signal-dedicated ground; and
an outer sheath of said coaxial cable is electrically connected to said upper cabinet and is also electrically connected to a ground of a power supply provided in said lower cabinet.
